**Europäisches Patentamt**

**European Patent Office**

**Office européen des brevets**

(11) Numéro de publication: **0 245 166 B1**

# (12) FASCICULE DE BREVET EUROPEEN

(45) Date de publication de fascicule du brevet: **05.08.92** (51) Int. Cl.⁵: **H01B 7/08,** F17C 13/00

(21) Numéro de dépôt: **87401011.9**

(22) Date de dépôt: **30.04.87**

(54) **Câble plat de connexions électriques à résistances thermique et électrique controlées.**

(30) Priorité: **05.05.86 FR 8606478**

(43) Date de publication de la demande:
**11.11.87 Bulletin 87/46**

(45) Mention de la délivrance du brevet:
**05.08.92 Bulletin 92/32**

(84) Etats contractants désignés:
**BE CH DE ES GB IT LI LU NL**

(56) Documents cités:
**FR-A- 2 353 013**
**GB-A- 980 468**
**US-A- 3 828 111**

(73) Titulaire: **COMMISSARIAT A L'ENERGIE ATO-MIOUE Etablissement de Caractère Scientifique Technique et Industriel**
**31/33, rue de la Fédération**
**F-75015 Paris(FR)**

(72) Inventeur: **Massit, Claude**
**4, Avenue Albert 1er de Belgique**
**F-38000 Grenoble(FR)**
Inventeur: **Nicolas, Gérard**
**Les Tilleuls**
**F-38340 Voreppe(FR)**

(74) Mandataire: **Mongrédien, André et al**
**c/o BREVATOME 25, rue de Ponthieu**
**F-75008 Paris(FR)**

Rank Xerox (UK) Business Services

## Description

La présente invention concerne les lignes électriques destinées à relier des points entre lesquels les transferts thermiques doivent être contrôlés et limités, notamment entre une source chaude et une source froide. Deux domaines d'application évidents mais non limitatifs sont la cryogénie et le spatial.

Actuellement, on emploie beaucoup les câbles en acier inoxydable pour de telles utilisations ; ils présentent toutefois l'inconvénient, outre leur prix assez élevé, d'être volumineux et pesants et de posséder une résistance électrique assez élevée. Enfin, ils ne permettent pas de moduler la température le long du câble, comme on pourrait le souhaiter.

On a également envisagé une conception différente qui consiste à déposer des couches de cuivre sur un support isolant, généralement souple, appelé "limande" dans le milieu spécialisé, mais qui peut aussi être localement ou entièrement rigide. Ces couches sont interrompues aux endroits où on désire une bonne isolation thermique et on les relie par des fils de manganin soudés sur ces pistes et fixés par un procédé quelconque sur le support isolant. Le cuivre possède l'avantage d'une faible résistance électrique, alors que les liaisons au manganin, matériau doté d'une forte résistance thermique, constituent des barrières aux échanges de chaleur le long des connexions. Toutefois, la pose des fils de manganin ne peut être effectuée de façon suffisamment fiable pour constituer une solution pleinement satisfaisante.

La présente invention apporte donc une amélioration dans la conception de ces câbles plats par une fabrication plus simple et fiable ainsi que par la possibilité de moduler les caractéristiques de résistance électrique et thermique le long des lignes de tels câbles.

De façon plus précise, cette invention comprend tout d'abord un support plat, isolant thermique et électrique, qui peut être souple, rigide ou encore rigide par morceaux selon le cas ; des fabrications en polyimide ou en verre époxy, par exemple, peuvent être avantageusement employées.

Sur au moins une face de ce support isolant plan, on implante les lignes de connexion, qui sont constituées de deux couches superposées. La première d'entre elles, qui s'étend sur toute la longueur de la ligne, est en un matériau à faible conductivité thermique. La seconde couche est quant à elle en un matériau à très bonne conductivité électrique et thermique. On connaît déjà un tel câble, par exemple du document GB-A-980 468. le câble selon la présente invention est caractérisé par la partie caractérisante de la revendication 1.

Suivant un mode préféré de l'invention, le matériau constitutif de la première couche est du manganin, celui de la seconde couche un métal tel que le cuivre, ou encore l'or.

Selon un exemple de réalisation, l'épaisseur et la largeur des couches de conducteurs le long des lignes de connexion, ainsi que la longueur des zones sur lesquelles la couche conductrice discontinue est implantée, peuvent être variables de façon à pouvoir régler les dissipations thermiques et électriques le long des lignes de connexion.

Le principe et les caractéristiques de l'invention seront mieux compris à travers la description qui suit, donnée à titre indicatif et non limitatif, en référence aux dessins annexés, sur lesquels :
- la figure 1 représente en perspective un câble muni de plusieurs lignes parallèles établies suivant l'invention,
- la figure 2 représente une vue de côté d'une ligne établie suivant l'invention (2b), ainsi qu'un diagramme de températures possibles le long de cette ligne (2a),
- la figure 3 représente une coupe transversale d'un câble multicouches obtenu par superposition de plusieurs câbles du type de ceux représentés figures 1 et 2,
- la figure 4 représente une vue de côté d'une ligne de câble plat à isolation thermique fabriquée suivant l'art antérieur,
- les figures 5 et 6 représentent deux modes supplémentaires possibles de réalisation de câbles selon l'invention.

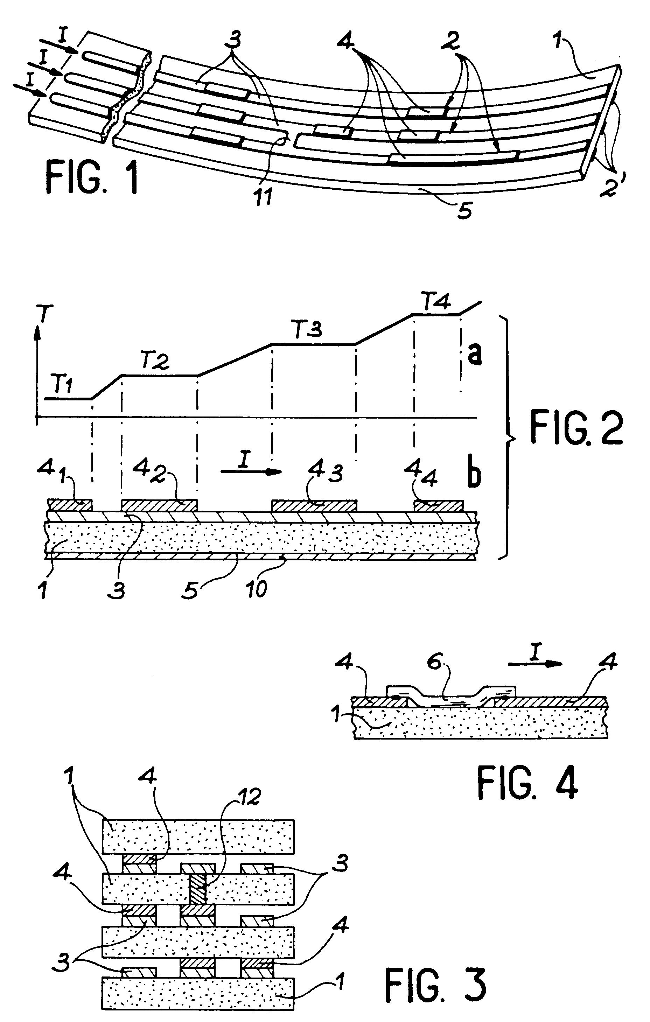

Le câble représenté figure 1 est donc composé d'un support isolant 1 et de plusieurs lignes de connexion 2. Chacune de ces lignes est constituée d'une couche de manganin continue 3 et d'une couche discontinue formée des segments 4 de métal conducteur électrique comme il apparaît plus clairement sur la figure 2b, qui montre en outre comment les dépôts de métal 4.1 à 4.4 permettent d'échelonner la température le long de la ligne.

En effet, le courant et la chaleur parcourent de façon préférentielle le métal 4 partout où il existe : il en résulte (figure 2a) des zones à faible résistance électrique et à température uniforme. En revanche, le courant et la chaleur doivent utiliser la couche de manganin 3 pour leur propagation aux endroits où la seconde couche est interrompue. Ces endroits correspondent donc à des barrières thermiques à cause de la mauvaise conductivité thermique du manganin, au prix d'une résistance électrique un peu plus élevée.

On arrive donc, de façon plus satisfaisante, au résultat obtenu par le principe déjà connu représenté figure 4, où les couches de cuivre 4 sont reliées par des fils de manganin 6 soudés à leurs extrémités sur le cuivre 4 et sont fixées par un procédé quelconque, tel que du papier adhésif, sur un support isolant 1.

A partir des lignes construites suivant le principe des figures 1 et 2, il est possible d'envisager diverses réalisations pratiques des câbles :

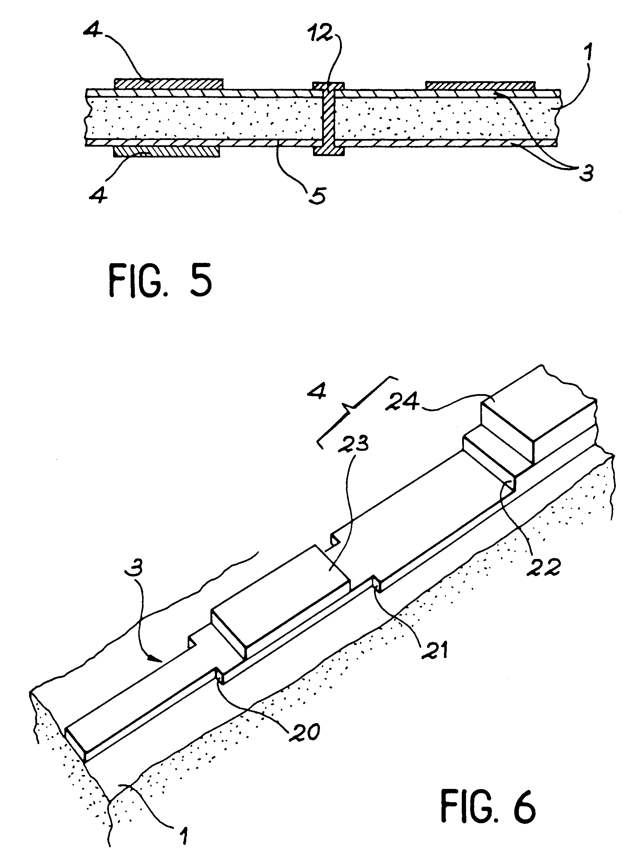

- le support plan 1 permet d'implanter en parallèle plusieurs lignes 2, comme le représente la figure 1 :
- on peut utiliser la seconde face 5 du support isolant 1. Selon un premier mode de réalisation de l'invention, cette seconde face 5 de l'isolant supporte d'autres lignes de connexion 2'. Selon un deuxième mode de réalisation de l'invention, cette face 5 supporte un plan de masse 10 qui assure le blindage du câble,
- le blindage du câble peut encore être assuré par certaines des lignes de connexion disposées sur le câble,
- les lignes 2 peuvent être reliées électriquement entre elles, soit au moyen de raccordements conducteurs 11 (figure 1) disposés sur une face entre deux ou plusieurs lignes adjacentes, soit par perçage du support isolant 1 et mise en place d'une traversée ou cheville conductrice 12 (figures 3 et 5) entre deux lignes situées sur les faces opposées de ce support,
- il est encore possible de fabriquer des câbles multicouches par superposition de plusieurs épaisseurs de supports isolants 1 munis de leurs conducteurs 3 et 4, comme la figure 3 le représente.

D'une façon générale, les lignes 2 et 2' peuvent présenter des discontinuités dans la largeur et l'épaisseur des couches des deux conducteurs 3 et 4 : la figure 6 représente une couche de manganin 3 qui présente deux discontinuités de largeur 20 et 21 et une discontinuité d'épaisseur 22, et une couche de cuivre 4 formée de deux parties 23 et 24 de largeur et d'épaisseur également différentes.

Cette nouvelle conception de câbles à faible conductivité thermique offre donc un certain nombre d'avantages par rapport à la solution connue auparavant et représentée figure 4, d'après laquelle les segments de métal conducteur 4 sont reliés entre eux par des fils de manganin 6 soudés à leurs extrémités et collés par un procédé quelconque sur l'isolant 1 : la technologie proposée par l'invention est plus simple et fiable tout en permettant des dissipations thermiques et électriques réglées plus finement. Ces caractéristiques favorables devraient faciliter la pénétration de l'invention dans des industries de pointe telles que le spatial, d'autant plus que le poids et le prix de tels câbles plats sont en principe plus réduits que pour des circuits équivalents en acier inoxydable formés de câbles ronds, et la densité de lignes que l'on peut implanter plus importante.

## Revendications

1. Câble plat de connexions électriques composé d'un support isolant plan (1) sur au moins une face duquel des lignes de connexion (2) sont implantées, dans lequel les lignes de connexion (2) sont constituées de deux couches superposées, la première (3) d'entre elles, qui s'étend sur toute la longueur des lignes (2), étant en matériau à faible conductivité thermique, la seconde couche (4) étant quant à elle en matériau à la fois très bon conducteur électrique et thermique, le câble étant caractérisé en ce que la seconde couche est discontinue, les longueurs des segments (4) de la seconde couche et leurs espacements étant variables de façon à pouvoir régler les dissipations thermiques et électriques le long des lignes de connexion (2).

2. Câble plat suivant la revendication 1, caractérisé en ce que plusieurs lignes (2) sont implantées en parallèle sur le même support isolant (1).

3. Câble plat selon l'une quelconque des revendications 1 ou 2, caractérisé en ce que l'épaisseur et la largeur des couches (3, 4) de conducteurs le long des lignes de connexion (2), ainsi que la longueur des zones sur lesquelles la couche conductrice discontinue (4) est implantée, sont variables (20, 21, 22, 23, 24).

4. Câble plat selon l'une quelconque des revendications 1 à 3, caractérisé en ce que certaines des lignes de connexion (2) sont affectées au blindage de câble.

5. Câble plat selon l'une quelconque des revendications 1 à 4, caractérisé en ce que la seconde face (5) du support isolant (1) supporte d'autres lignes de connexion (2') ou un plan de masse (10) utilisé pour le blindage du câble.

6. Câble plat suivant la revendication 4, caractérisé en ce que des chevilles conductrices (12) traversent les supports isolants (1) pour permettre de relier entre elles des lignes (2) situées sur les deux faces opposées desdits supports (1).

7. Câble plat multicouche, caractérisé en ce que la superposition de plusieurs épaisseurs de supports isolants (1) munis de leurs conducteurs (3, 4) suivant la revendication 1.

8. Câble plat suivant la revendication 7, caractérisé en ce que des chevilles conductrices (12) traversent les supports isolants (1) pour permettre de relier entre elles des lignes (2) situées sur les deux faces opposées desdits supports (1).

**Claims**

1. Flat electrical connecting cable formed from a planar insulating support (1), on at least one face of which are installed connecting lines (2), wherein these connecting lines (2) are constituted by two superimposed layers, the first (3) of them, which extends over the entire length of the lines, being made from a material having a low thermal conductivity, the second layer (4) being made from a material which is both a good electrical and thermal conductor, the cable being characterized in that the second layer is discontinuous, the lengths of the segments (4) of the second layer and their spacings being variable, so as to be able to regulate the electrical and thermal dissipations along the connecting lines (2).

2. Flat cable according to claim 1, characterized in that several lines (2) are installed in parallel on the same insulating support (1).

3. Flat cable according to either of the claims 1 or 2, characterized in that the thickness and width of the conductive layers (3, 4) along the connecting lines (2), as well as the length of the zones on which the discontinuous conductive layer (4) is installed are variable.

4. Flat cable according to any one of the claims 1 to 3, characterized in that certain of the connecting lines (2) are used for shielding the cable.

5. Flat cable according to any one of the claims 1 to 4, characterized in that the second face (5) of the insulating support (1) supports other connecting lines (2') or a mass plane (10) used for shielding the cable.

6. Flat cable according to claim 4, characterized in that conductive pins (12) traverse the insulating supports (1) to make it possible to interconnect lines (2) located on two opposite faces of said supports (1).

7. Flat multilayer cable, characterized by super imposing several thicknesses of insulating supports (1) provided with their conductors (3, 4) in accordance with claim 1.

8. Flat cable according to claim 7, characterized in that conductive pins (12) traverse the insulating supports (1) in order to permit the interconnection of the lines (2) located on the two opposite faces of said supports (1).

**Patentansprüche**

1. Flachkabel für elektrische Verbindungen, das aus einem isolierenden, flachen Träger (1) besteht, wobei auf wenigstens einer Seite desselben Verbindungsleitungen (2) implantiert sind, in dem die Verbindungsleitungen (2) aus zwei übereinander liegenden Schichten bestehen, wobei die erste (3) von diesen, die sich über die gesamte Länge der Leitungen (2) erstreckt, aus einem Material mit geringer Wärmeleitfähigkeit besteht, wobei die zweite Schicht (4) ihrerseits aus einem Material besteht, das zur gleichen Zeit ein guter elektrischer und ein guter Wärmeleiter ist, wobei das Kabel dadurch gekennzeichnet ist, daß die zweite Schicht diskontinuierlich ist, wobei die Längen der Abschnitte (4) der zweiten Schicht und ihre Abstände variabel sind, so daß die thermischen und elektrischen Dissipationen entlang der Verbindungsleitungen (2) geregelt werden können.

2. Flachkabel nach Anspruch 1, dadurch gekennzeichnet, daß mehrere Leitungen (2) parallel auf demselben isolierenden Träger (1) implantiert sind.

3. Flachkabel nach einem der Ansprüche 1 oder 2, dadurch gekennzeichnet, daß die Dicke und die Breite der Leiterschichten (3, 4) entlang der Verbindungsleitungen (2) ebenso wie die Länge der Bereiche, in der die diskontinuierliche Leiterschicht (4) implantiert ist, variabel sind (20, 21, 22, 23, 24).

4. Flachkabel nach einem der Ansprüche 1 bis 3, dadurch gekennzeichnet, daß bestimmte Verbindungsleitungen (2) zur Abschirmung des Kabels eingesetzt sind.

5. Flachkabel nach einem der Ansprüche 1 bis 4, dadurch gekennzeichnet, daß die zweite Seite (5) des isolierenden Trägers (1) andere Verbindungsleitungen (2') oder eine Masseebene (10) trägt, die zur Abschirmung des Kabels verwendet wird.

6. Flachkabel nach Anspruch 4, dadurch gekennzeichnet, daß leitende Stifte (12) die isolierenden Träger (1) durchqueren, um Verbindungen zwischen den Leitungen (2), die sich auf den beiden gegenüberliegenden Seiten der Träger (1) befinden, zu ermöglichen.

7. Mehrschichtiges Flachkabel, gekennzeichnet durch eine Überlagerung von mehreren Schichten von isolierenden Trägern (1) mit ihren Leitern (3, 4) nach Anspruch 1.

8. Flachkabel nach Anspruch 7, dadurch gekennzeichnet, daß Leiterstifte (12) die isolierenden Träger (1) durchqueren, um Verbindungen zwischen den Leitungen (2), die sich auf den beiden gegenüberliegenden Seiten der Träger (1) befinden, zu ermöglichen.

FIG. 1

FIG. 2

FIG. 4

FIG. 3

FIG. 5

FIG. 6